# EUROPÄISCHE PATENTSCHRIFT

(11) **EP 1 325 177 B1**
(45) Veröffentlichungstag und Bekanntmachung des Hinweises auf die Patenterteilung: **22.06.2005**
(21) Anmeldenummer: 01980316.2
(22) Anmeldetag: 31.08.2001
(51) Int. Cl.: C30B 25/14, C23C 16/455

(54) **VERFAHREN ZUM ABSCHEIDEN VON INSBESONDERE KRISTALLINEN SCHICHTEN, GASEINLASSORGAN SOWIE VORRICHTUNG ZUR DURCHFÜHRUNG DES VERFAHRENS**
METHOD FOR DEPOSITING, IN PARTICULAR, CRYSTALLINE LAYERS, A GAS INLET ELEMENT, AND DEVICE FOR CARRYING OUT SAID METHOD
PROCEDE POUR DEPOSER NOTAMMENT DES COUCHES CRISTALLINES, DISPOSITIF D'ENTREE DE GAZ ET DISPOSITIF POUR METTRE LEDIT PROCEDE EN OEUVRE

(30) Priorität: 22.09.2000 DE 10047562; 23.12.2000 DE 10064944
(43) Veröffentlichungstag der Anmeldung: 09.07.2003
(73) Patentinhaber: Aixtron AG, 52072 Aachen (DE)
(72) Erfinder: STRAUCH, Gerd, 52072 Aachen (DE); REINHOLD, Markus, 52074 Aachen (DE)
(74) Vertreter: Grundmann, Dirk, Dr.
(86) Internationale Anmeldenummer: PCT/EP2001/010078
(87) Internationale Veröffentlichungsnummer: WO 2002/027078

(56) Entgegenhaltungen:
- EP-A- 0 334 432
- US-A- 6 080 642

## Beschreibung

Die Erfindung betrifft ein Verfahren zum Abscheiden von insbesondere kristallinen Schichten auf insbesondere ebenfalls kristallinen Substraten, wobei zumindest zwei Prozessgase getrennt voneinander in eine Prozesskammer eines Reaktors eingeleitet werden, wobei das erste Prozessgas durch eine zentrale Leitung mit einer zentralen Austrittsöffnung und das zweite Prozessgas durch eine dazu periphere Leitung mit peripherer Austrittsöffnung strömt, wobei das zweite Prozessgas durch mehrere Zuleitungen in eine Mischkammer und durch weitere, den Gasstrom beeinflussende Mittel zur Homogenisierung des Radialströmungsprofiles des aus der peripheren Austrittsöffnung austretenden Prozessgases strömt.

Die Erfindung betrifft ferner ein Gaseinlassorgan an einer Vorrichtung zum Abscheiden von insbesondere kristallinen Schichten auf insbesondere ebenfalls kristallinen Substraten, mittels welchem zumindest zwei Prozessgase getrennt voneinander in eine Prozesskammer eines Reaktors einleitbar sind, mit einer zentralen Leitung mit zentraler Austrittsöffnung für das erste Prozessgas und mit einer dazu peripheren Leitung mit peripherer Austrittsöffnung für das zweite Prozessgas, welche periphere Leitung zwischen ein oder mehreren in eine Mischkammer mündenden Zuleitungen und der peripheren Austrittsöffnung den Gasstrom beeinflussende Mittel besitzt zur Homogenisierung des Radialströmungsprofil des aus der peripheren Austrittsöffnung austretenden Prozessgases.

Eine derartige Vorrichtung ist beispielsweise aus der US 6,080,642 vorbekannt. Diese Schrift offenbart ein Gaseinlassorgan mit zwei Gaszuleitungen für jeweils ein Prozessgas, die getrennt voneinander der Prozesskammer zugeführt werden. Arsin oder Phosphin werden dort durch eine zentrale Leitung durch das Gaseinlassorgan geführt. Die zentrale Leitung endet an der Stirnseite des im Wesentlichen rotationssymmetrisch aufgebauten Gaseinlassorgans. Das zweite Prozessgas wird mittels einer einzigen Rohrleitung vom Gasmischsystem dem Gaseinlassorgan zugeführt. Im Bereich des Gaseinlassorganes verzweigt sich diese Zuleitung zunächst in zwei sekundäre Zuleitungen. Diese beiden sekundären Zuleitungen verzweigen sich sodann wieder in jeweils zwei tertiäre Zuleitungen, so dass insgesamt vier Leitungen symmetrisch in eine Mischkammer münden. Von dieser Mischkammer gehen Einzelkanäle aus, die sich zu einer peripheren Austrittsöffnung weiter verzweigen. Zufolge Fluktuationen im Rohrdurchmesser kann es bei dieser kaskadenartigen Aufspaltung zu inhomogenen Strömungsverhältnissen kommen. Darüber hinaus eignet sich diese Aufspaltung nicht für eine einseitige, unsymmetrische Zuführung zweier Gase getrennt voneinander.

Der Erfindung liegt die Aufgabe zugrunde, Mittel anzugeben, mit denen auch eine asymmetrische Zuleitung des zweiten Prozessgases in die Mischkammer möglich ist und trotzdem auch bei verschiedenartigen Prozessparametern beziehungsweise Reaktorgeometrien ein homogenes Radialströmungsprofil des aus der Austrittsöffnung austretenden zweiten Prozessgases ermöglichbar ist.

Der Erfindung liegt weiter die Aufgabe zugrunde, ein Verfahren anzugeben, mit welchem mit einfachen Mitteln ein homogenes Radialströmungsprofil erreichbar ist.

Gelöst wird die Aufgabe durch die in den Ansprüchen angegebene Erfindung. Das im Anspruch 1 vorgeschlagene Verfahren sieht vor, dass das zweite Prozessgas durch ein der Mischkammer nachgeordnetes Strömungs-Beeinflussungsorgan insbesondere in Form einer Ringdrossel oder eines Drallerzeugers und durch eine diesem nachgeordnete ringförmige Vorkammer strömt und durch einen gasdurchlässigen Gasauslassring austritt.

Das im Anspruch 7 angegebene Gaseinlassorgan und die im Anspruch 22 angegebene Vorrichtung sehen ein der Mischkammer nachgeordnetes Strömungs-Beeinflussungsorgan beispielsweise eine Ringdrossel oder ein Drallerzeuger und eine diesem nachgeordnete ringförmige Vorkammer vor, welche von einem gasdurchlässigen Gasauslassring umgeben ist. Die Verfahrensparameter beziehungsweise die geometrischen Parameter sind dabei so gewählt, dass der Strömungswiderstand der Ringdrossel derart größer ist, als der Strömungswiderstand des Gasauslassringes, dass der Druckunterschied zwischen Vorkammer und Mischkammer größer ist, als der Druckunterschied zwischen Vorkammer und Prozesskammer. In einer bevorzugten Ausgestaltung unterscheiden sich diese beiden Druckunterschiede um mindestens einen Faktor 10. Bevorzugt liegt der Unterschied aber höher. Es können mehrere, insbesondere zwei Zuleitungen asymmetrisch in die Mischkammer münden. Die Zuleitungen münden bevorzugt schräg, insbesondere in Umfangsrichtung schräg in die Mischkammer. Die durch die Zuleitungen fließenden Gasströme können einzeln geregelt sein. Es ist insbesondere vorgesehen, dass durch die Zuleitungen unterschiedliche Gase strömen. Beispielsweise kann durch eine Zuleitung Trimethylgallium oder Trimethylindium oder dergleichen fließen. Durch die andere, in die Mischkammer mündende Zuleitung kann ein metallorganischer Dotierstoff fließen. Die Strömungsparameter sind dabei so eingestellt, dass die Leitungen bis zu den Austrittsöffnungen auf einer Temperatur gehalten sind, bei denen ein Zerfall der Reaktionsgase innerhalb des Gaseinlassorganes weitestgehend vermieden wird, so dass insbesondere eine Deposition an dem Gasauslassring vermieden ist. Die Ringdrossel kann aus einem gasundurchlässigen Werkstoff bestehen, der eine Vielzahl von Einzelkanälen aufweist. Insbesondere kann die Ringdrossel aus Quarz bestehen. Die Zahl der Einzelkanäle kann zu der Anzahl der Zuleitungen teilerfremd sein. Dies hat zur Folge, dass sich zwischen den Mündungen der Zuleitungen und der Einzelkanäle in Umfangsrichtung unterschiedliche Abstände bilden. Insbesondere sind weder die Mündungen der Zuleitungen noch die Einzelkanäle punktsymmetrisch zur Zentralachse des Gaseinlassorganes angeordnet. Auch dies trägt zur Homogenisierung des Radial-Strömungsprofils bei. In einer Variante der Erfindung besteht die Drossel aus einem porösem Material, beispielsweise aus porösem Quarz. Sie ist insbesondere als Fritte gestaltet. Sie kann aber auch aus Edelstahl, insbesondere einem Edelstahlschaum bestehen. Der Gasauslassring kann ebenfalls aus einem porösem Material, beispielsweise Quarz bestehen. In einer Variante besitzt der Gasauslassring eine Vielzahl, bevorzugt zu den Einzelkanälen der Ringdrossel teilerfremde Anzahl von Austrittskanälen. Die Austrittskanäle können von kammartigen, insbesondere schrägen Einschnitten gebildet sein. Der Durchmesser des Gasauslassringes kann größer sein, als der Durchmesser der Ringdrossel. In dem Raum vor der Ringdrossel, der Mischkammer bildet sich ein Gasdruck, der erheblich höher ist, als der Gasdruck hinter der Ringdrossel, so dass durch die Ringdrossel ein umfangssymmetrischer Gasstrom strömt. Dieser umfangssymmetrische Gasstrom mündet in die Vorkammer. Ebenso wie die Mischkammer ist die Vorkammer ringförmig um die zentrale Leitung angeordnet. Die Vorkammer ist vorzugsweise ununterteilt, so dass sich in der Vorkammer ein in Umfangsrichtung nahezu gleicher Druck einstellt, welcher geringfügig höher ist, als der Druck in der den Gasauslassring umgebenden Prozesskammer. Zufolge dieses geringfügigen Druckunterschiedes strömt das Gas vorzugsweise laminar durch den Gasauslassring und zwar in Umfangsrichtung homogen.

In einer Weiterbildung der Erfindung kann der Mischkammer auch ein Drallerzeuger nachgeordnet werden. Das aus der Mischkammer weiter strömende Gas wird durch diesen Drallerzeuger in eine zentrale Ringstromkammer geleitet, wo es zur Folge der dort stattfindenden Verwirbelung vermischt. Diesem Drallerzeuger kann sich eine Ringdrossel anschließen. Gemäß einer erfindungsgemäßen Variante besitzt die Vorrichtung einen der Mischkammer nachgeordneten Drallerzeuger und eine diesem nachgeordnete ringförmige Vorkammer, welche von einem gasdurchlässigen Gasauslassring umgeben ist. Dieser Drallerzeuger erzeugt in der Ringstromkammer, die unmittelbar den Einzelkanälen des Drallerzeugers nachgeordnet ist, eine Ringströmung, so dass sich dort die Reaktionsgase vermischen können. Bevorzugt münden die radial einwärts durchströmten Einzelkanäle des Drallerzeugers mit einer Neigung zur Achsquerebene in die Ringstromkammer. Die Ringstromkammer kann sich in Stromabwärtsrichtung verbreitern. Sie kann nach radial auswärts von einem in Stromaufwärtsrichtung überströmbaren Umleitkragen begrenzt werden. In den verbreiterten Fortsatz der Ringstromkammer bildet sich zufolge der Strömungsumlenkung in die Gegenrichtung ein stationärer torusförmiger Wirbel aus. Auch dieser Wirbel bewirkt eine Homogenisierung der Gaszusammensetzung. Zusammen mit der die zentrale Zuleitung umströmenden Umfangsströmung in der Ringstromkammer bewirkt dieser torusförmige Wirbel eine Verbesserung der Gasdurchmischung. Da das Volumen der Ringstromkammer inklusive der stromabwärts angeordneten Verbreitung im Bereich ein- oder mehrerer Milliliter liegt, haben die Wirbel nur eine vernachlässigbare Speicherfunktion. Dem Umleitkragen kann rückwärtig eine Ringdrossel zugeordnet sein. Diese Ringdrossel kann eine Vielzahl von Bohrungen besitzen, durch welche das Gas strömt. Die Bohrungen können auf eine Prallwand eines Umlenkkragens gerichtet sein. Dieser Umlenkkragen kann von einem radial einwärts gerichteten Vorsprung ausgebildet sein, welcher vom Gas umströmt wird.

Eine Variante des Verfahrens besteht darin, dass mindestens zwei Zuleitungen in die Mischkammer münden. Durch eine der Zuleitungen strömt erfindungsgemäß mehr als zehnmal so viel Gas, als durch die mindestens eine weitere Zuleitung. Durch diesen erheblichen Unterschied in den Volumenströmen findet eine bessere Durchmischung des Gases in der Mischkammer statt. Bei dieser Prozessführung kann sogar auf eine Ringdrossel oder ein Drallerzeuger verzichtet werden. Bevorzugt strömt durch die eine Zuleitung mehr als fünfzehnmal so viel Gas als durch die mindestens eine weitere beziehungsweise durch alle weiteren Zuleitungen zusammen.

Nachfolgend werden Ausführungsbeispiele der Erfindung anhand von beigefügten Zeichnungen erläutert. Es zeigen:
- Fig. 1: ein erstes Ausführungsbeispiel der Erfindung in einer Schnittdarstellung, wobei die wesentlichen Bestandteile des in einem Reaktor eingebauten Gaseinlassorganes schematisch dargestellt sind,
- Fig. 2: ein Schnitt gemäß der Linie II-II in Figur 1,
- Fig. 3: ein Schnitt gemäß der Linie III-III in Figur 1,
- Fig. 4: ein Schnitt gemäß der Linie IV-IV in Figur 1,
- Fig. 5: ein zweites Ausführungsbeispiel der Erfindung in einer Darstellung gemäß Fig. 1,
- Fig. 6: ein drittes Ausführungsbeispiel der Erfindung in einer Darstellung gemäß Fig. 1,
- Fig. 7: ein Schnitt der Linie VII-VII in Figur 6,
- Fig. 8: ein viertes Ausführungsbeispiel der Erfindung in einer Darstellung gemäß Figur. 1,
- Fig. 9: ein fünftes Ausführungsbeispiel der Erfindung in einer Darstellung gemäß Figur 1,
- Fig. 10: ein sechstes Ausführungsbeispiel der Erfindung in einer Darstellung gemäß Figur 1,
- Fig. 11: einen Schnitt gemäß der Linie XI-XI in Figur 10,
- Fig. 12: in schematischer Darstellung die Zuleitungen zum Gaseinlassorgan,
- Fig. 13: ein siebtes Ausführungsbeispiel der Erfindung und
- Fig. 14: einen Schnitt gemäß der Linie XIII-XIII in Figur 12.

Das Gaseinlassorgan findet Verwendung in einem Epitaxi-Reaktor, in welchem insbesondere aus metallorganischen Verbindungen und Hydriden Halbleiterschichten auf Halbleitersubstraten abgeschieden werden. Eine derartige Vorrichtung zeigt beispielsweise das US-Patent 6,080,642. Der Reaktor besitzt einen im Wesentlichen kreisscheibenförmigen Substrat-Träger, auf welchem planetenartig die auf drehangetriebenen Substrathaltern liegenden Substrate angeordnet sind. Das Gaseinlassorgan gemäß der Erfindung ist darüberhinaus auch für andere Vorrichtungen zum Abscheiden von insbesondere kristallinen Schichten auf insbesondere ebenfalls kristallinen Substraten geeignet. Insbesondere kann das erfindungsgemäße Gaseinlassorgan zufolge eines modulen Aufbaus an unterschiedlichem Prozessparameter wie Trägergase (Wasserstoff, Stickstoff oder Edelgase) und Prozesstemperaturen angepasst werden. Das Gaseinlassorgan kann darüber an verschiedene Prozesstemperaturen durch Wahl geeigneter Komponeten angepasst werden.

Der Reaktor besitzt eine Prozesskammer 1, die einen Prozesskammerboden 1' und eine Prozesskammerdecke 1'' besitzt. Im Zentrum der Prozesskammer 1 befindet sich das Gaseinlassorgan. Dieses ragt bereichsweise in den Zwischenraum zwischen Boden 1' und Decke 1''. Das Gaseinlassorgan besitzt eine zentrale Leitung 2, durch welche Arsin oder Phosphin in die Prozesskammer 1 strömt. Dieses Hydrid tritt aus einer im Wesentlichen trichterförmigen zentralen Austrittsöffnung 3 an der Stirnseite des Gaseinlassorganes aus. An der peripheren Umfangsseite des Gaseinlassorganes befindet sich ein Gasauslassring 6, der sich auf einem Randabschnitt eines Gasauslassringträgers 14 abstützt, welcher auch die zentrale Leitung 2 ausbildet. Mit seiner oberen Stirnfläche liegt der Gasauslassring 6 gegen die Decke 1'' der Prozesskammer 1.

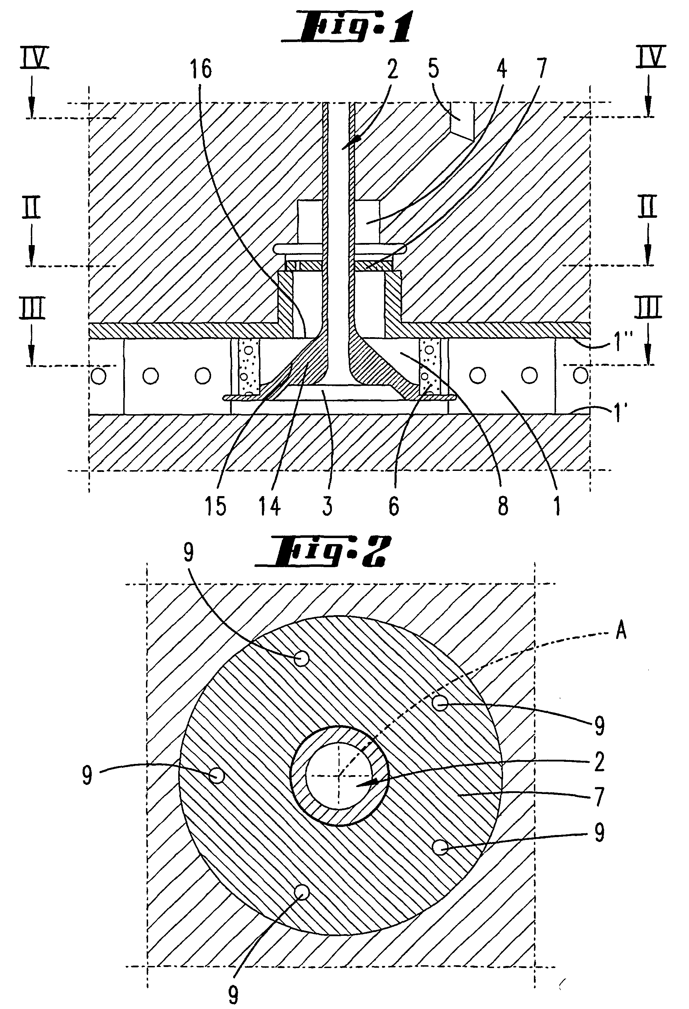

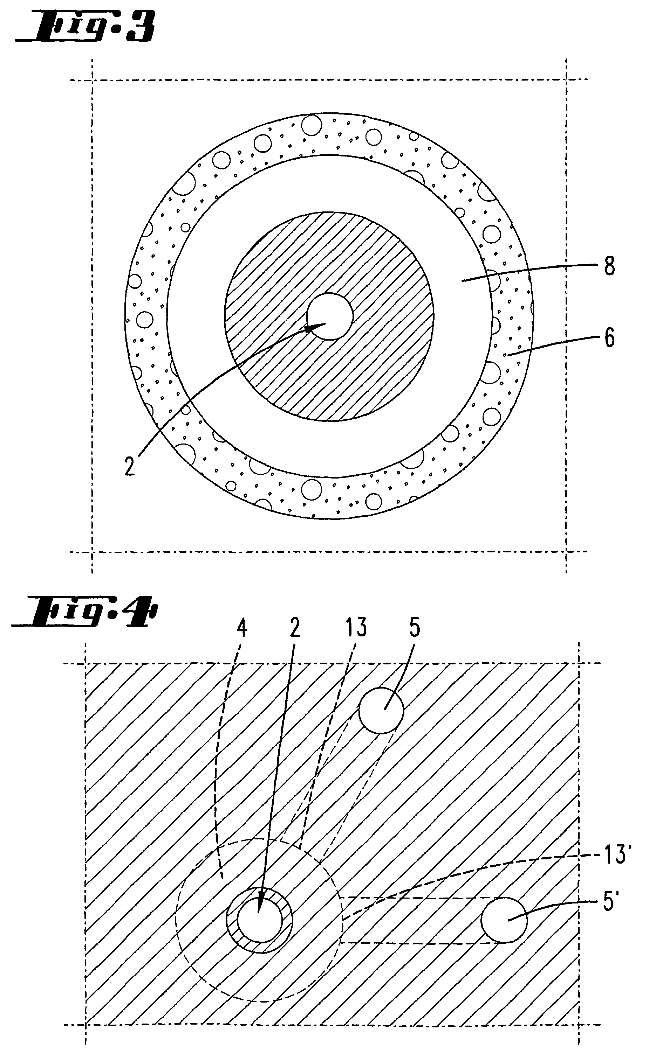

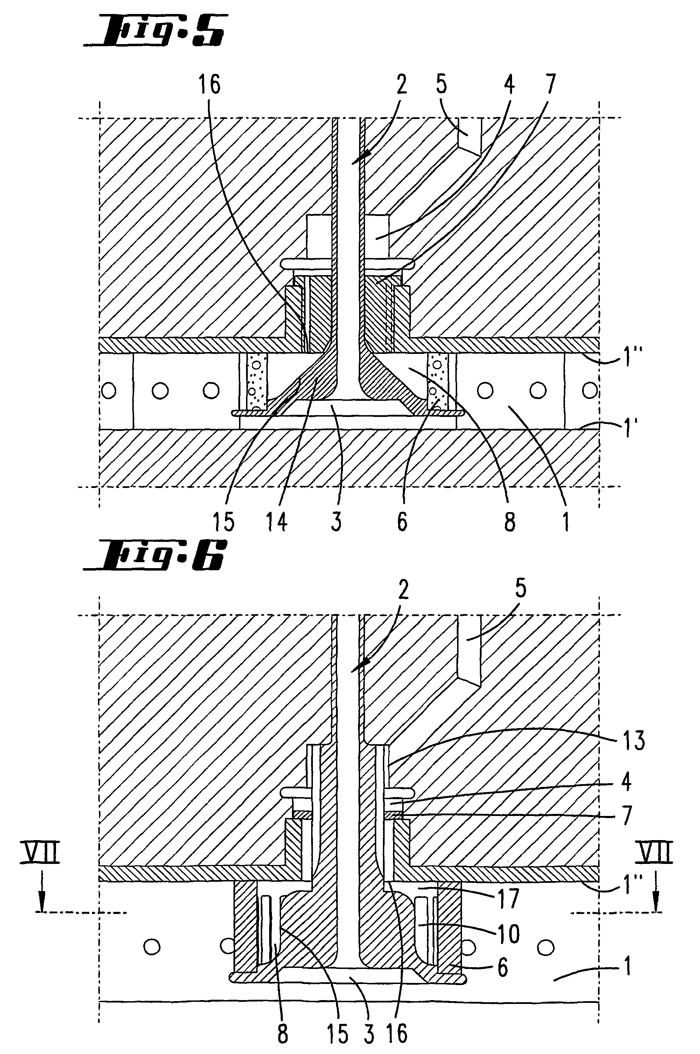

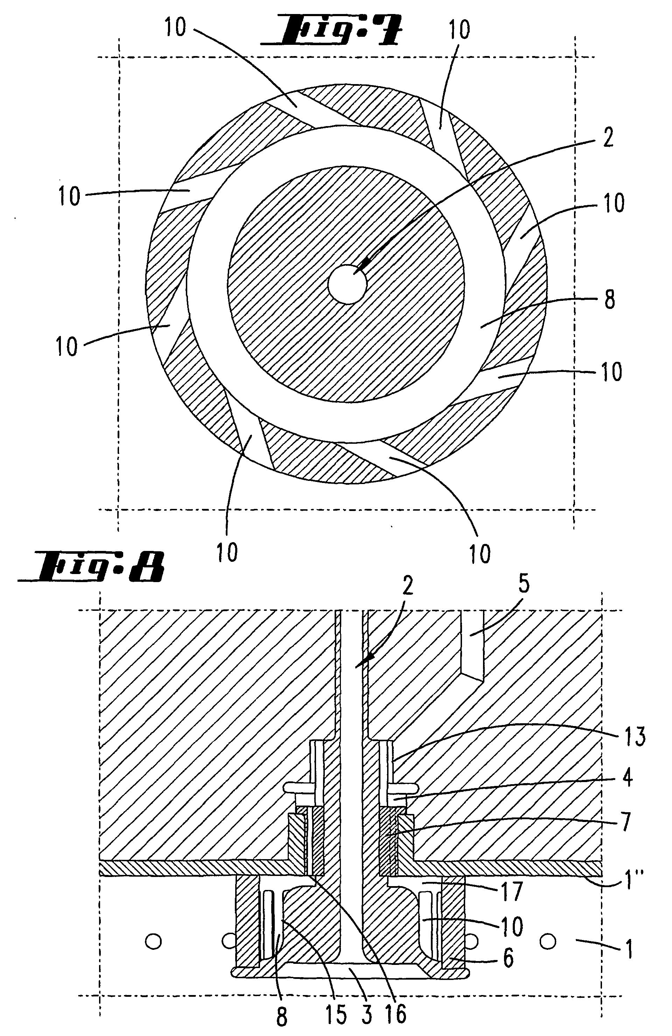

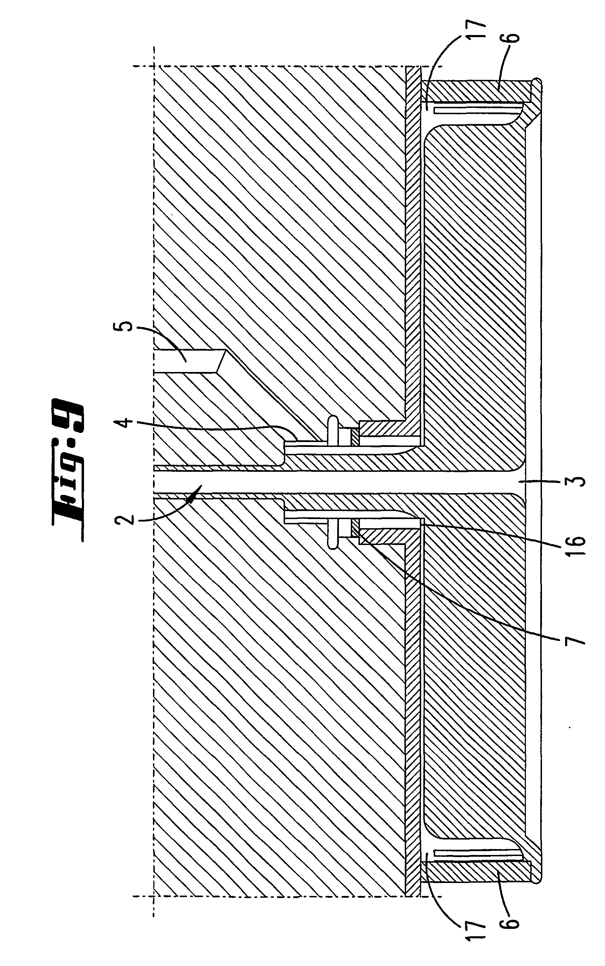

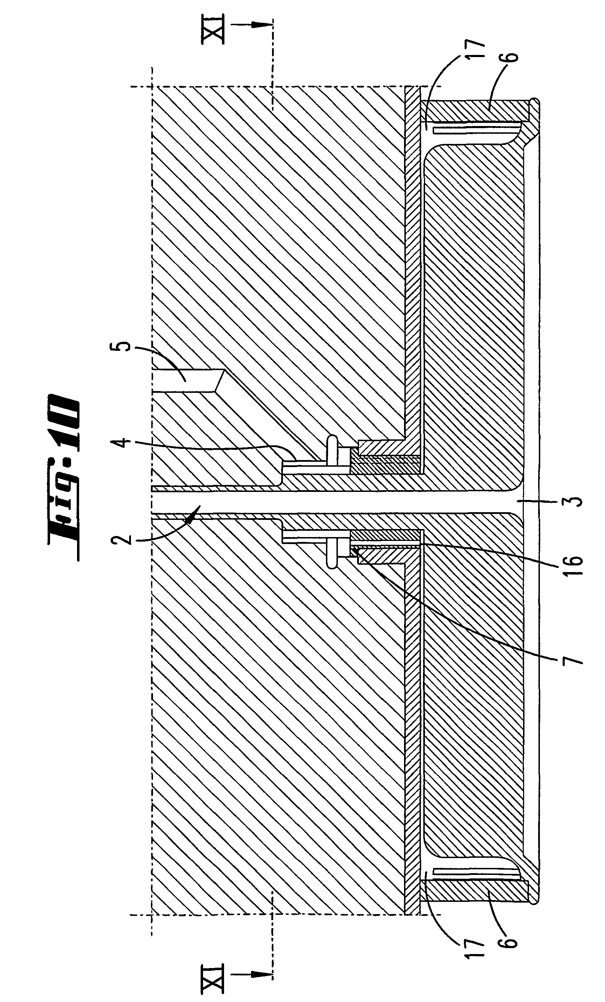

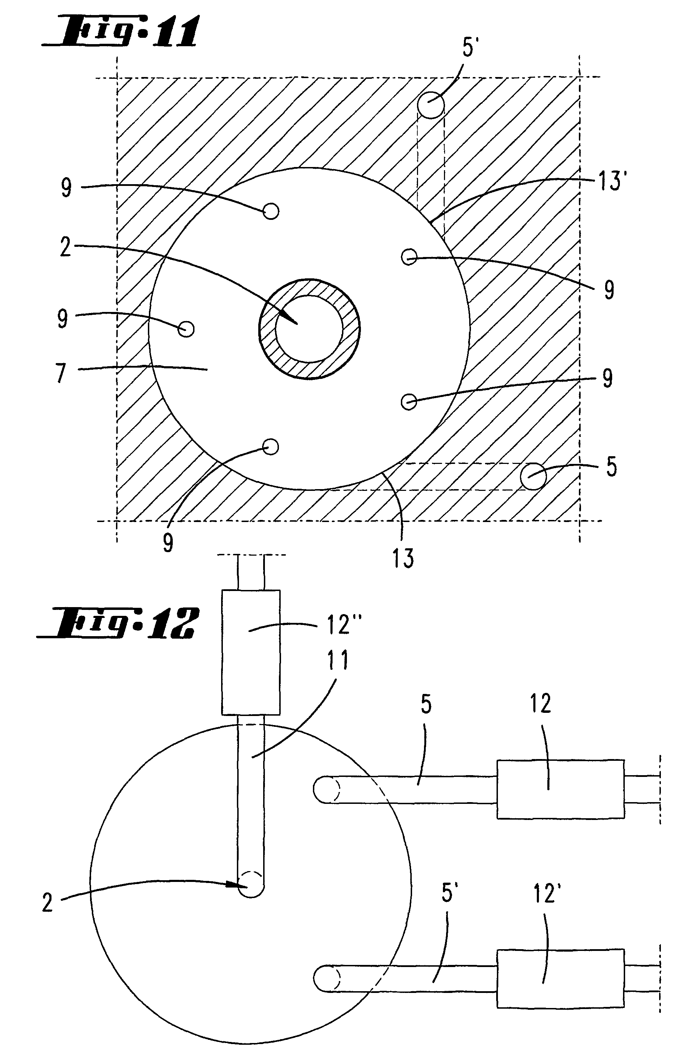

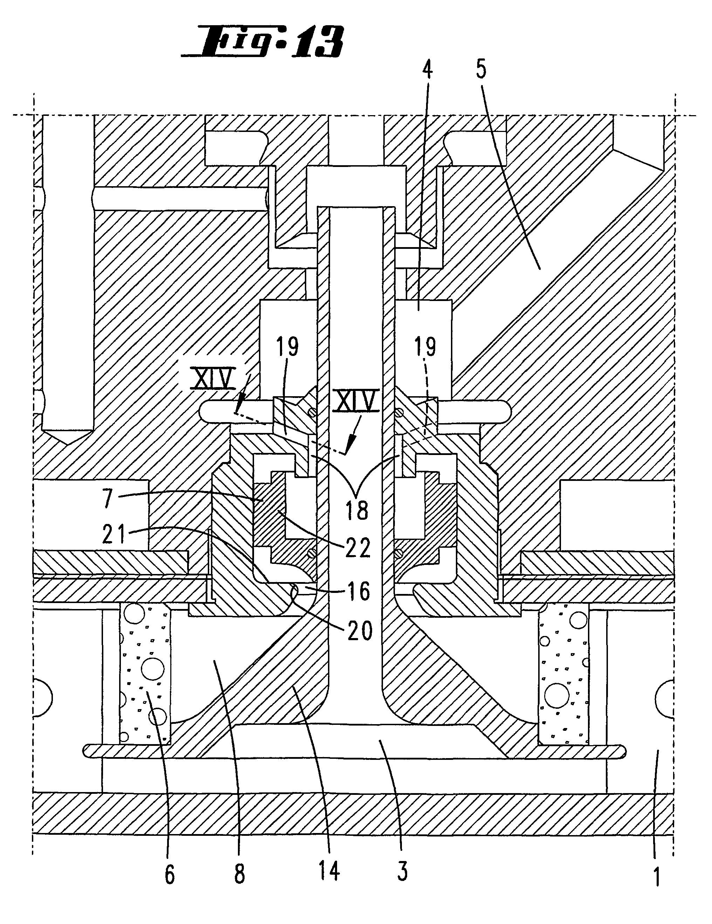

Der Gasauslassring 6 ist dadurch gasdurchlässig, dass er entweder aus einem porösen Material gefertigt ist oder Öffnungen besitzt. Die Öffnungen können als Schlitze ausgebildet sein. Das in den ersten beiden Ausführungsbeispielen (Figuren 1 bis 5) dargestellte Ausführungsbeispiel besitzt einen Gasauslassring 6, der aus porösem Quarz gefertigt ist. Bei dem in den Figuren 6 bis 10 dargestellten Ausführungsbeispiel besitzt der Gasauslassring 6 eine Vielzahl von Austrittskanälen 10, die als zum einen Rand des Gasauslassringes 6 offene Schlitze ausgebildet sind. Insgesamt hat dieser Gasauslassring 6 somit eine kammartige Struktur.

Wie aus der Figur 7 ersichtlich ist, können die einzelnen Austrittskanäle 10 als schräg zum Zentrum verlaufende Einschnitte ausgebildet sein.

Rückwärtig des Gasauslassringes 6 befindet sich eine ringförmige Vorkammer 8. Die Rückwand 15 der Vorkammer 8 ist abhängig von der Gestaltung des Gasauslassringes 6 geformt. Ist der Gasauslassring 6 als poröser Körper geformt, so hat die Rückwand 15 bevorzugt eine kegelstumpfförmige Gestalt, so dass der Gasauslassring 6 auch in Achsrichtung gleichmäßig vom zweiten Prozessgas durchströmt wird.

Stromaufwärts der Vorkammer 8 befindet sich in dem Gasauslassorgan eine ringförmige Höhlung. In dieser ringförmigen Höhlung befindet sich eine ringförmige Drossel 7. Bei dem in Figur 1 dargestellten Ausführungsbeispiel besteht die Ringdrossel 7 aus einer Quarz-Kreisscheibe mit fünf Einzelkanälen 9, die entweder parallel zur Achse des Gasauslassorganes ausgerichtet sind, oder schräg dazu.

Bei dem in der Figur 5 dargestellten Ausführungsbeispiel ist die Ringdrossel 7 ähnlich gestaltet. Sie besitzt jedoch eine erheblich größere Dicke. Das heisst, bei dem in Figur 5 dargestellten Ausführungsbeispiel sind die Einzelkanäle 9 länger, als bei dem in Figur 1 dargestellten Ausführungsbeispiel.

Bei dem Ausführungsbeispiel der Figuren 6 bis 10 hat die Vorkammerrückwand 15 eine glockenartige Struktur, so dass sich ein schmaler Eintrittsspalt 16 ausbildet, dem eine Prallwand 17 gegenüberliegt. Die Prallwand 17 wird von einem Randabschnitt des Gasauslassringes gebildet, von welchem die kammartigen Zinken ausgehen. Stromaufwärts des Eintrittsspaltes 16 befindet sich auch dort die Ringdrossel 7, die einen kleineren Durchmesser besitzt, als der Gasauslassring 6.

Die Drossel kann auch aus einem porösen Material bestehen, beispielsweise aus einem porösen Quarz. Es ist auch denkbar, die Drossel 7 aus einem Edelstahlschaum oder aus einem anderen, einen Strömungswiderstand entfaltenden Material zu fertigen. Die Eigenschaften von Ringdrossel 7 und Gaseinlassring 6 sind so aufeinander abgestimmt, dass die Ringdrossel 7 dem Gasstrom einen größeren Strömungswiderstand entgegensetzt, als der Gasauslassring 6. Dies hat zur Folge, dass der Druckunterschied zwischen der stromaufwärts der Ringdrossel 7 angeordneten Mischkammer 4 und der Vorkammer 8 größer ist, als der Druckunterschied zwischen der Vorkammer 8 und der Prozesskammer 1. Der Unterschied der beiden Druckdifferenzen beträgt mindestens den Faktor 10. Er kann aber auch einen Faktor 100 betragen. So kann sich an der Drossel beispielsweise ein Druckunterschied von 1 bis 100 mbar einstellen, während der Druckunterschied zwischen Vorkammer und Prozesskammer lediglich 0,1 mbar beträgt.

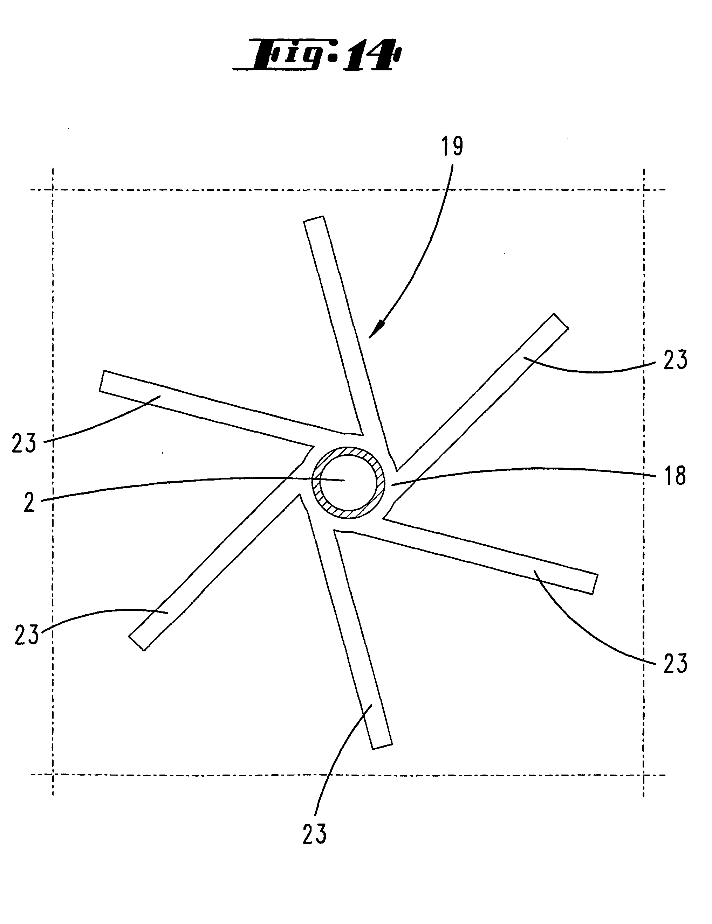

Wie insbesondere den Figuren 4, 11 und 12 zu entnehmen ist, liegen die Zuleitungen 5 des zweiten Prozessgases asymmetrisch zur zentralen Achse A, welche im Zentrum der zentralen Leitung 2 liegt. Die beiden Zuleitungen 5, 5' münden an den mit den Bezugsziffern 13 beziehungsweise 13' bezeichneten Stellen in die ringförmige Mischkammer 4. Sie können dabei schräg zur Radialen in die Mischkammer 4 münden, so dass sich eine Rotationsbewegung des Gasstromes in der Mischkammer 4 einstellen kann.

Den zwei Zuleitungen 5, 5' beziehungsweise Mündungsöffnungen 13, 13' sind im Ausführungsbeispiel fünf Einzelkanäle 9 zugeordnet. Diesen fünf Einzelkanälen 9 sind sechzehn Austrittskanäle 10 des Gasauslassringes 6 zugeordnet.

Wie aus der Figur 12 zu entnehmen ist, besitzt jede der beiden Zuleitungen 5, 5' einen einzelnen Massenflussregler 12, 12' zur Regelung des Gaszuflusses.
Einen derartigen Massenflussregler 12''' besitzt auch die Zuleitung 11 zur zentralen Leitung 2.

Das in den Figuren 9 und 10 dargestellte Ausführungsbeispiel besitzt einen Gasauslassringträger 14, der eine vergrößerte Stirnfläche und einen vergrößerten Umfangskragen besitzt, auf dem ein Gasauslassring 6 mit einem großem Durchmesser sitzt.

Die Wahl von Durchmessern des Gasauslassringes 6 beziehungsweise von der Fläche der Austrittskanäle 10 und deren Abstimmung auf den Strömungswiderstand der Ringdrossel 7 erfolgt entsprechend der Viskosität und der Dichte des verwendeten Gases.

Es erfolgt bevorzugt eine derartige Wahl, das die Reynoldszahl in den Einzelkanälen 9 der Drossel größer ist, als die Reynoldszahl in den Austrittskanälen 10 des Gasauslassringes.

Bei dem in den Figuren 13 und 14 dargestellten Ausführungsbeispiel ist hinter der Mischkammer 4 ein Drallerzeuger 19 angeordnet. Dieser Drallerzeuger 19 besitzt eine Vielzahl von schräg und geneigt zur Axialquerebene radial einwärts gerichtete Einzelkanäle 23, die tangential in eine im Bereich der Ummantelung der zentralen Leitung 2 angeordneten Ringstromkammer 18 münden. Zufolge der tangentialen Mündung der Einzelkanäle 23 in die Ringstromkammer 18 bildet sich dort ein um die zentrale Leitung 22 laufender Wirbel aus.

Die Ringstromkammer 18 setzt sich in Stromabwärtsrichtung fort und vergrößert sich dabei in Radialrichtung. Radial auswärts wird die Ringstromkammer 18 in diesem vergrößerten Bereich von einem Umleitkragen 22 begrenzt, der Stromaufwärtsrichtung vom Gas überströmt wird. In diesem vergrößerten Abschnitt, der der Ringstromkammer 18 nachgeordnet ist, bildet sich zufolge des Gegenstromes ein torusförmiger Wirbel aus.

Rückwärtig des Umleitkragens 22 sitzt eine Ringdrossel 7. Diese Ringdrossel 7 besteht aus einer Vielzahl von Axialbohrungen. Die in den Zeichnungen nicht dargestellten Axialbohrungen münden in Richtung auf eine Prallwand 21. Die Prallwand 21 wird von einem Umlenkkragen 20 gebildet, der sich radial einwärts erstreckt und den Eintrittsspalt 16 ausbildet. Anstelle der Axialbohrungen können auch schräg verlaufende Bohrungen vorgesehen sein.

Gemäß einer Weiterbildung des erfindungsgemäßen Verfahrens ist vorgesehen, dass in die Mischkammer 4 mindestens zwei Zuleitungen 5 münden. Durch eine dieser Zuleitungen soll erfindungsgemäß mindestens zehnmal soviel Gas strömen, bevorzugt fünfzehnmal soviel Gas strömen, wie durch alle anderen in die Mischkammer mündenden Zuleitungen 5. Hierdurch bilden sich in der Mischkammer 4 Wirbel, so dass der stromabwärts gerichtete Gasstrom in Umfangsrichtung eine nahezu homogene Gaszusammensetzung erhält.

## Patentansprüche

1. Verfahren zum Abscheiden von insbesondere kristallinen Schichten auf insbesondere ebenfalls kristallinen Substraten, wobei zumindest zwei Prozessgase getrennt voneinander in eine Prozesskammer (1) eines Reaktors eingeleitet werden, wobei das erste Prozessgas durch eine zentrale Leitung (2) mit einer zentralen Austrittsöffnung (3) und das zweite Prozessgas durch eine dazu periphere Leitung (4) mit peripherer Austrittsöffnung strömt, wobei das zweite Prozessgas durch ein oder mehrere Zuleitungen (5) in eine Mischkammer (4) und durch weitere, den Gasstrom beeinflussende Mittel zur Homogenisierung des Radialströmungsprofils des aus der peripheren Austrittsöffnung austretenden Prozessgases strömt, **dadurch gekennzeichnet, dass** das zweite Prozessgas durch ein der Mischkammer (4) nachgeordnetes Strömungsbeeinflussungsorgan insbesondere in Form einer Ringdrossel (7) oder eines Drallerzeugers (19) und durch eine diesem nachgeordnete ringförmige Vorkammer strömt und durch einen gasdurchlässigen Gasauslassring (6) austritt.

2. Verfahren nach Anspruch 1, **dadurch gekennzeichnet, dass** der Strömungswiderstand der Ringdrossel (7) derart größer ist, als der Strömungswiderstand des Gasauslassringes (6), dass der Druckunterschied zwischen Vorkammer (8) und Mischkammer (4) größer ist, als der Druckunterschied zwischen Vorkammer (8) und Prozesskammer (1).

3. Verfahren nach Anspruch 2 oder insbesondere danach, **dadurch gekennzeichnet, dass** die beiden Druckunterschiede sich um mindestens einen Faktor zehn unterscheiden.

4. Verfahren nach einem der vorhergehenden Ansprüche, **dadurch gekennzeichnet, dass** die durch die Zuleitungen (5, 5') fließenden Gasströme einzeln geregelt (12,12') sind.

5. Verfahren zum Abscheiden von insbesondere kristallinen Schichten auf insbesondere ebenfalls kristallinen Substraten, wobei zumindest zwei Prozessgase getrennt voneinander in eine Prozesskammer (1) eines Reaktors eingeleitet werden, wobei das erste Prozessgas durch eine zentrale Leitung (2) mit einer zentralen Austritts Öffnung (3) und das zweite Prozessgas durch eine dazu periphere Leitung (4) mit peripherer Austrittsöffnung strömt, wobei das zweite Prozessgas durch mindestens zwei Zuleitungen (5) in eine Mischkammer (4) und durch weitere, den Gasstrom beeinflussende Mittel zur Homognisierung des Radialströmungsprofils des aus der peripheren Austrittsöffnung austretenden Prozessgases strömt, **dadurch gekennzeichnet, dass** durch eine der in die Mischkammer (4) mündenden Zuleitungen (5) mehr als zehnmal soviel Gas strömt als durch die mindestens eine weitere Zuleitung (5).

6. Verfahren nach Anspruch 5, **dadurch gekennzeichnet, dass** durch die eine Zuleitung (5) mehr als fünfzehnmal soviel Gas strömt als durch die mindestens eine weitere Zuleitung.

7. Gaseinlassorgan an einer Vorrichtung zum Abscheiden von insbesondere kristallinen Schichten auf insbesondere ebenfalls kristallinen Substraten, mittels welchem zumindest zwei Prozessgase getrennt voneinander in eine Prozesskammer (1) eines Reaktors einleitbar sind, mit einer zentralen Leitung (2) mit zentraler Austrittsöffnung (3) für das erste Prozessgas und mit einer dazu peripheren Leitung (4) mit peripherer Austrittsöffnung für das zweite Prozessgas, welche periphere Leitung zwischen ein oder mehreren in eine Mischkammer (4) mündenden Zuleitungen (5) und der peripheren Austritts- öffnung angeordnete, den Gasstrom beeinflussende Mittel besitzt zur Homogenisierung des Radialströmungsprofils des aus der peripheren Austrittsöffnung austretenden Prozessgases, **gekennzeichnet durch** ein der Mischkammer (4) nachgeordnetes StrömungsBeeinflussungsorgan insbesondere in Form einer Ringdrossel (7) oder eines Drallerzeugers (19) und eine diesem nachgeordnete ringförmige Vorkammer (8), welche von einem gasdurchlässigen Gasauslassring (6) umgeben ist.

8. Gaseinlassorgan nach Anspruch 7, **dadurch gekennzeichnet, dass** zwei oder mehrere Zuleitungen (5) verzweigungsfrei in die Mischkammer (4) münden.

9. Gaseinlassorgan nach einem der vorhergehenden Ansprüche, **dadurch gekennzeichnet, dass** die Zuleitungen (5) asymmetrisch in die Mischkammer (4) münden.

10. Gaseinlassorgan nach einem der vorhergehenden Anspruche, **dadurch gekennzeichnet, dass** die Zuleitungen schräg, insbesondere in Umfangsrichtung schräg in die Mischkammer münden.

11. Gaseinlassorgan nach einem der vorhergehenden Ansprüche, **dadurch gekennzeichnet, dass** die Ringdrossel (7) eine Vielzahl von achsparallelen oder schräg zur Achse (A) verlaufende Einzelkanäle (9) aufweist, wobei insbesondere deren Zahl zur Anzahl der Zuleitungen (5, 5') teilerfremd ist.

12. Gaseinlassorgan nach einem der vorhergehenden Ansprüche, **dadurch gekennzeichnet, dass** die Mündungen (13,13') der Zuleitungen (5,5') und/oder die Einzelkanäle(9) nicht punktsymmetrisch zur Zentral-Achse (A) des Gaseinlassorganes angeordnet sind.

13. Gaseinlassorgan nach einem der vorhergehenden Ansprüche, **dadurch gekennzeichnet, dass** die Ringdrossel (7) aus einem porösen Material, insbesondere aus Quarz oder Edelstahl besteht.

14. Gaseinlassorgan nach einem der vorhergehenden Ansprüche, **dadurch gekennzeichnet, dass** der Gasauslassring (6) eine Vielzahl, bevorzugt zu den Einzelkanälen (9) der Ringdrossel (7) teilerfremde Anzahl von Austrittskanälen (10) besitzt.

15. Gaseinlassorgan nach Anspruch 14, **dadurch gekennzeichnet, dass** die Austrittskanäle (10) von kammartigen, insbesondere schrägen Einschnitten gebildet sind.

16. Gaseinlassorgan nach einem der vorhergehenden Ansprüche, **dadurch gekennzeichnet, dass** der Durchmesser des Gasaustrittsringes (6) grösser ist, als der Durchmesser der Ringdrossel (7).

17. Gaseinlassorgan nach einem der vorhergehenden Ansprüche, **dadurch gekennzeichnet, dass** der Gasaustrittsring (6) von einem Randkragen eines Gasauslassringträgers (14) getragen wird, dessen kegelstumpf-oder glockenförmige Außenwand die Vorkammerückwand (15) bildet, und in dessen Stirnfläche die zentrale Austrittsöffnung (3) angeordnet ist.

18. Gaseinlassorgan nach einem der vorhergehenden Ansprüche, **dadurch gekennzeichnet, dass** radial einwärts durchströmte Einzelkanäle (23) des Drallerzeugers (19) mit einer Neigung zur Achsquerebene in eine Ringstromkammer (18) münden.

19. Gaseinlassorgan nach Anspruch 18, **dadurch gekennzeichnet, dass** sich die Ringstromkammer (18) in Stromabwärtsrichtung verbreitert und radial auswärts von einem in Stromaufwärtsrichtungüberströmbaren Umleitkragen (22) begrenzt wird.

20. Gaseinlassorgan nach Anspruch 19, **gekennzeichnet durch** eine radial auswärts des Umleitkragens (22) angeordnete Ringdrossel (7).

21. Gaseinlassorgan nach einem der vorhergehenden Ansprüche, **dadurch gekennzeichnet, dass** eine Vielzahl von die Ringdrossel (7) bildende Bohrungen auf eine Prallwand (21) eines Umlenkkragens (20) gerichtet sind.

22. Vorrichtung zum Abscheiden von insbesondere kristallinen Schichten auf insbesondere ebenfalls kristallinen Substraten mit einem Gaseinlassorgan gemäss einem oder mehreren der vorhergehenden Ansprüche.

23. Vorrichtung gemäß Anspruch 22, **dadurch gekennzeichnet, dass** die förmige Stirnwand des Gasauslassringes (6) an die Decke (1 ") einer Prozesskammer (1) angrenzt.

24. Vorrichtung nach einem der Ansprüche 22 oder 23, **dadurch gekennzeichnet, dass** der Mischkammer ein Drallerzeuger (19) nachgeordnet ist.

## Claims

1. Method for separating in particular crystalline layers on in particular also crystalline substrates, wherein at least two process gases are introduced separately from each other into a process chamber (1) of a reactor, wherein the first process gas flows through a central pipe (2) with a central outlet opening (3) and the second process gas flows through a pipe (4) peripheral thereto with a peripheral outlet opening, wherein the second process gas flows through one or more supply pipes (5) into a mixing chamber (4) and through further means influencing the gas stream for homogenising the radial flow profile of the process gas leaving the peripheral outlet opening, **characterised in that** the second process gas flows through a flow control member mounted behind the mixing chamber (4), in particular in the form of a ring throttle (7) or a swirl generator (19), and through an annular preliminary chamber mounted behind the latter and through a gas-permeable gas outlet ring (6).

2. Method according to claim 1, **characterised in that** the flow resistance of the ring throttle (7) is so much greater than the flow resistance of the gas outlet ring (6) that the pressure difference between preliminary chamber (8) and mixing chamber (4) is greater than the pressure difference between preliminary chamber (8) and process chamber (1).

3. Method according to claim 2 or in particular according thereto, **characterised in that** the two pressure differences differ by at least a factor of ten.

4. Method according to any of the preceding claims, **characterised in that** the gas streams flowing through the supply pipes (5, 5') are individually regulated (12, 12').

5. Method for separating in particular crystalline layers on in particular also crystalline substrates, wherein at least two process gases are introduced separately from each other into a process chamber (1) of a reactor, wherein the first process gas flows through a central pipe (2) with a central outlet opening (3) and the second process gas flows through a pipe (4) peripheral thereto with a peripheral outlet opening, wherein the second process gas flows through at least two supply pipes (5) into a mixing chamber (4) and through further means influencing the gas stream for homogenising the radial flow profile of the process gas leaving the peripheral outlet opening, **characterised in that** more than ten times as much gas flows through one of the supply pipes (5) leading into the mixing chamber (4), than through the at least one further supply pipe (5).

6. Method according to claim 5, **characterised in that** more than fifteen times as much gas flows through one supply pipe (5), than through the at least one further supply pipe.

7. Gas inlet member on an apparatus for separating in particular crystalline layers on in particular also crystalline substrates, by means of which at least two process gases can be introduced separately from each other into a process chamber (1) of a reactor, with a central pipe (2) with central outlet opening (3) for the first process gas and with a pipe (4) peripheral thereto with peripheral outlet opening for the second process gas, which peripheral pipe has means arranged between one or more supply pipes (5) leading into a mixing chamber (4) and the peripheral outlet opening, and influencing the gas stream, for homogenising the radial flow profile of the process gas leaving the peripheral outlet opening, **characterised by** a flow control member mounted behind the mixing chamber (4), in particular in the form of a ring throttle (7) or a swirl generator (19), and an annular preliminary chamber (8) mounted behind the latter and surrounded by a gas-permeable gas outlet ring (6).

8. Gas inlet member according to claim 7, **characterised in that** two or more supply pipes (5) lead without branching into the mixing chamber (4).

9. Gas inlet member according to any of the preceding claims, **characterised in that** the supply pipes (5) lead asymmetrically into the mixing chamber (4).

10. Gas inlet member according to any of the preceding claims, **characterised in that** the supply pipes lead obliquely, in particular in the circumferential direction obliquely into the mixing chamber.

11. Gas inlet member according to any of the preceding claims, **characterised in that** the ring throttle (7) has a plurality of individual channels (9) having parallel axes or running obliquely to the axis (A), wherein in particular the number thereof is prime relative to the number of supply pipes (5, 5').

12. Gas inlet member according to any of the preceding claims, **characterised in that** the openings (13, 13') of the supply pipes (5, 5') and/or the individual channels (9) are arranged not point-symmetrically to the central axis (A) of the gas inlet member.

13. Gas inlet member according to any of the preceding claims, **characterised in that** the ring throttle (7) is made of a porous material, in particular quartz or special steel.

14. Gas inlet member according to any of the preceding claims, **characterised in that** the gas outlet ring (6) has a plurality, preferably a number of outlet channels (10) which is prime relative to the individual channels (9) of the ring throttle (7).

15. Gas inlet member according to claim 14, **characterised in that** the outlet channels (10) are formed by comb-like, in particular oblique notches.

16. Gas inlet member according to any of the preceding claims, **characterised in that** the diameter of the gas outlet ring (6) is larger than the diameter of the ring throttle (7).

17. Gas inlet member according to any of the preceding claims, **characterised in that** the gas outlet ring (6) is carried by an edge collar of a gas outlet ring support (14) whose frustoconical or bell-shaped outer wall forms the rear wall (15) of the preliminary chamber, and in whose end face is arranged the central outlet opening (3).

18. Gas inlet member according to any of the preceding claims, **characterised in that** individual channels (23) of the swirl generator (19) with radially inward throughflow lead into a ring-flow chamber (18) at an angle to the axial transverse plane.

19. Gas inlet member according to claim 18, **characterised in that** the ring-flow chamber (18) widens in the downstream direction and is defined radially outwards by a re-routing collar (22) over which the fluid can flow upstream.

20. Gas inlet member according to claim 19, **characterised by** a ring throttle (7) arranged radially outwards of the re-routing collar (22).

21. Gas inlet member according to any of the preceding claims, **characterised in that** a plurality of bores forming the ring throttle (7) are directed onto a baffle (21) of a deflecting collar (20).

22. Apparatus for separating in particular crystalline layers on in particular also crystalline substrates with a gas inlet member according to one or more of the preceding claims.

23. Apparatus according to claim 22, **characterised in that** the shaped end wall of the gas outlet ring (6) adjoins the top (1") of a process chamber (1).

24. Apparatus according to either of claims 22 or 23, **characterised in that** behind the mixing chamber is mounted a swirl generator (19).

## Revendications

1. Procédé de déposition de couches, en particuliers cristallines, sur des substrats, en particuliers également cristallins, dans lequel
au moins deux gaz de processus sont introduits séparément dans une chambre de processus (1) d'un réacteur,
le premier gaz de processus s'écoule dans une conduite centrale (2) présentant une ouverture de sortie centrale (3) et le deuxième gaz de processus s'écoule dans une conduite (4) périphérique à la conduite centrale (2) et présentant une ouverture de sortie périphérique,
le deuxième gaz de processus entre dans une chambre de mélange (4) par une ou plusieurs conduites d'amenée (5) et s'écoule dans d'autres moyens influant sur le flux de gaz pour homogénéiser le profil d'écoulement radial du gaz de processus sortant par l'ouverture de sortie périphérique,
**caractérisé en ce que** le deuxième gaz de processus s'écoule dans un élément influençant l'écoulement, monté en aval de la chambre de mélange (4) et se présentant en particulier sous la forme d'un étrangleur annulaire (7) ou d'un générateur de torsion (19), et dans une préchambre annulaire placée en aval de cet élément influençant l'écoulement et sort par une bague de sortie de gaz (6) perméable aux gaz.

2. Procédé selon la revendication 1, **caractérisé en ce que** la résistance à l'écoulement de l'étrangleur annulaire (7) est supérieure à la résistance à l'écoulement de la bague de sortie de gaz (6), de sorte que la différence de pression entre la préchambre (8) et la chambre de mélange (4) est supérieure à la différence de pression entre la préchambre (8) et la chambre de processus (1).

3. Procédé selon la revendication 2, ou en particulier selon celle-ci, **caractérisé en ce que** les deux différences de pression diffèrent d'un facteur d'au moins 10.

4. Procédé selon l'une des revendications précédentes, **caractérisé en ce que** les flux de gaz s'écoulant dans les conduites d'amenée (5, 5') sont régulés individuellement (12, 12').

5. Procédé de déposition de couches, en particuliers cristallines, sur des substrats, en particuliers également cristallins, dans lequel
au moins deux gaz de processus sont introduits séparément dans une chambre de processus (1) d'un réacteur,
le premier gaz de processus s'écoule dans une conduite centrale (2) présentant une ouverture de sortie centrale (3) et le deuxième gaz de processus s'écoule dans une conduite (4) périphérique à la conduite centrale (2) et présentant une ouverture de sortie périphérique,
le deuxième gaz de processus entre dans une chambre de mélange (4) par au moins deux conduites d'amenée (5) et s'écoule dans d'autres moyens influant sur le flux de gaz pour homogénéiser le profil d'écoulement radial du gaz de processus sortant par l'ouverture de sortie périphérique,
**caractérisé en ce qu'**il y a plus de dix fois plus de gaz qui s'écoule dans l'une des conduites d'amenée (5) débouchant dans la chambre de mélange (4) que dans l'au moins une autre conduite d'amenée (5).

6. Procédé selon leurs revendications 5, **caractérisé en ce qu'**il y a plus de quinze fois plus de gaz qui s'écoule dans l'une des conduites d'amenée (5) que dans l'au moins une autre conduite d'amenée (5).

7. Elément d'admission de gaz au niveau d'un dispositif de déposition de couches, en particulier cristallines, sur des substrats, en particulier également cristallins, permettant d'introduire au moins deux gaz de processus séparément dans une chambre de processus (1) d'un réacteur, et comportant une conduite centrale (2) présentant une ouverture de sortie centrale (3) destinée au premier gaz de processus et une conduite (4) périphérique à la conduite centrale (2) présentant une ouverture de sortie périphérique destinée au deuxième gaz de processus, laquelle conduite périphérique possédant des moyens influençant le flux de gaz qui sont disposés entre une ou plusieurs conduites d'amenée (5) débouchant dans une chambre de mélange (4) et l'ouverture de sortie périphérique afin d'homogénéiser le profil d'écoulement radial du gaz de processus sortant par l'ouverture de sortie périphérique, **caractérisé par** un élément influençant l'écoulement qui est placé en aval de la chambre de mélange (4) et qui se présente en particulier sous la forme d'un étrangleur annulaire (7) ou d'un générateur de torsion (19) et par une préchambre annulaire (8) qui est placée en aval de l'élément influençant l'écoulement et qui est entourée par une bague de sortie de gaz (6) perméable aux gaz.

8. Élément d'admission de gaz selon la revendication 7, **caractérisé en ce que** deux conduites d'amenée (5) ou plus débouchent sans ramification dans la chambre de mélange (4).

9. Élément d'admission de gaz selon l'une des revendications précédentes,
**caractérisé en ce que** les conduites d'amenée (5) débouchent de façon asymétrique dans la chambre de mélange (4).

10. Elément d'admission de gaz selon l'une des revendications précédentes,
**caractérisé en ce que** les conduites d'amenée débouchent obliquement dans la chambre de mélange, en particulier obliquement dans la direction périphérique.

11. Élément d'admission de gaz selon l'une des revendications précédentes,
**caractérisé en ce que** l'étrangleur annulaire (7) comporte un grand nombre de canaux individuels (9) s'étendant parallèlement à l'axe ou obliquement à l'axe (A), le nombre des canaux individuels (9) et le nombre des conduites d'amenée (5, 5') ayant, en particulier, comme plus grand commun diviseur le nombre 1.

12. Élément d'admission de gaz selon l'une des revendications précédentes,
**caractérisé en ce que** les embouchures (13, 13') des conduites (5, 5') et/ou les canaux individuels (9) ne sont pas disposés par symétrie ponctuelle par rapport à l'axe central (A) de l'élément d'admission de gaz.

13. Élément d'admission de gaz selon l'une des revendications précédentes,
**caractérisé en ce que** l'étrangleur annulaire (7) est en un matériau poreux, en particulier en quartz ou en acier fin.

14. Élément d'admission de gaz selon l'une des revendications précédentes,
**caractérisé en ce que** la bague de sortie de gaz (6) possède un grand nombre de canaux de sortie (10), le nombre de canaux de sortie (10) et nombre de canaux individuels (9) de l'étrangleur annulaire (7) ayant, de préférence, comme plus grand commun diviseur le nombre 1.

15. Élément d'admission de gaz selon la revendication 14, **caractérisé en ce que** les canaux de sortie (10) sont formés par des incisions, en particulier obliques, de type peigne.

16. Élément d'admission de gaz selon l'une des revendications précédentes,
**caractérisé en ce que** le diamètre de la bague de sortie de gaz (6) est supérieur au diamètre de l'étrangleur annulaire (7).

17. Élément d'admission de gaz selon l'une des revendications précédentes,
**caractérisé en ce que** la bague de sortie de gaz (6) est supportée par un rebord d'un support de bague de sortie de gaz (14) dont la paroi extérieure, en forme de cône tronqué ou de cloche, forme la paroi arrière (15) de la préchambre et dont la surface frontale est dotée de l'ouverture de sortie centrale (3).

18. Élément d'admission de gaz selon l'une des revendications précédentes,
**caractérisé en ce que** des canaux individuels (23), traversés radialement vers l'intérieur, du générateur de torsion (19) débouchent dans une chambre d'écoulement annulaire (18) avec une inclinaison par rapport au plan transversal à l'axe.

19. Elément d'admission de gaz selon la revendication 18, **caractérisé en ce que** la chambre d'écoulement annulaire (18) est élargie en aval par référence au sens d'écoulement et est limité radialement vers l'extérieur par un rebord de déviation (22) qui peut être débordé vers l'amont par référence au sens d'écoulement.

20. Élément d'admission de gaz selon la revendication 19, **caractérisé par** un étrangleur annulaire (7) placé radialement à l'extérieur du rebord de déviation (22).

21. Élément d'admission de gaz selon l'une des revendications précédentes,
**caractérisé en ce qu'**un grand nombre de perçages, formant l'étrangleur annulaire (7), sont dirigés vers une paroi de réflexion (21) d'un rebord de déviation (20).

22. Dispositif de déposition de couches, en particulier cristallines, sur des substrats, en particuliers également cristallins, comporte un élément d'admission de gaz selon l'une ou plusieurs des revendications précédentes.

23. Dispositif selon la revendication 22, **caractérisé en ce que** la paroi frontale formée de la bague de sortie de gaz (6) est bordée par le capot (1 ") d'une chambre de processus (1).

24. Dispositif selon l'une des revendications 22 ou 23, **caractérisé en ce qu'**un générateur de torsion (19) et placé en aval de la chambre de mélange.
